# EUROPÄISCHE PATENTSCHRIFT

(11) **EP 0 937 375 B1**
(45) Veröffentlichungstag und Bekanntmachung des Hinweises auf die Patenterteilung: **09.08.2000**
(21) Anmeldenummer: 97922835.0
(22) Anmeldetag: 16.04.1997
(51) Int. Cl.: H05K 9/00

(54) **ABGESCHIRMTER BAUGRUPPENTRÄGER FÜR ELEKTRISCHE FLACHBAUGRUPPEN**
SHIELDED SUB-RACK FOR ELECTRICAL CIRCUIT BOARDS
PORTE-CARTES BLINDE POUR CARTES ELECTRIQUES A CIRCUIT IMPRIME

(30) Priorität: 11.11.1996 DE 29619565 U
(43) Veröffentlichungstag der Anmeldung: 25.08.1999
(73) Patentinhaber: SIEMENS AKTIENGESELLSCHAFT, 80333 München (DE)
(72) Erfinder: BEHRENS, Ralf, D-90419 Nürnberg (DE); KOERBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9700758
(87) Internationale Veröffentlichungsnummer: WO9821923

(56) Entgegenhaltungen:
- DE-A- 3 604 860
- DE-C- 19 523 257
- DE-U- 29 602 426
- DE-U- 29 618 625
- US-A- 4 631 641

## Beschreibung

Im Grundaufbau enthält ein Baugruppenträger für elektrische Leiterplatten in aller Regel zwei Seitenwandbleche, welche durch Querschienen miteinander verbunden sind. Dabei wird die Front- und die Rückseite des Baugruppenträgers durch je ein Paar von oberen und unteren Querschienen gebildet. In diese Querschienen werden zur Bildung von sogenannten Einbauplätzen gegenüberliegende Paare von Führungsschienen eingerastet. In diese können die Leiterplatten, auch Flachbaugruppen genannt, senkrecht stehend parallel nebeneinander eingeschoben werden.

Leiterplatten weisen in aller Regel eine sogenannte Frontplatte auf, welche die Leiterplatte an einer Frontseite abdeckt und als Haltefläche für unterschiedlichste Anzeige-, Bedien- und Kontaktelemente dient. Die Frontplatten von senkrecht nebeneinander in einen Baugruppenträger eingeschobenen Leiterplatten bilden dann eine nahezu geschlossene, die Frontseite des Baugruppenträgers abdeckende Fläche.

Zum Zwecke der elektromagnetischen Abschirmung sind die Frontplatten von Leiterplatten zum einen aus einem elektrisch leitenden Material gefertigt bzw. zumindest von einem derartigen überzogen.

Aus der DE 36 04 860 C2 bzw. US 4,631,641 sind Anordnungen zur hochfrequenzdichten Abschirmung von vertikal nebeneinander liegenden Frontplatten an der Frontseite eines Baugruppenträgers bekannt. Dabei sind die Frontplatten über vertikale Kontaktfederleisten untereinander elektrisch leitend verbunden. Hiermit kann eine Abdichtung der vertikalen Nuten auf der Frontseite eines Baugruppenträgers gegen den Eintritt oder die Abstrahlung von elektromagnetischen Störungen bewirkt werden.

Ein Problem bei dieser elektromagnetischen Abdichtung tritt bei den unteren und oberen Schmalseiten einer jeden Frontplatte auf. An diesen Stellen sind zwar in aller Regel Montageschrauben vorhanden, worüber die Frontplatten mit z.B. Gewindelochschienen verschraubbar sind, welche in quer verlaufende Aufnahmenuten an den Frontseiten der unteren und oberen Querschienen des Baugruppenträgers eingeschoben sind. Über diese Montageschrauben ist eine elektrisch leitende Verbindung zwischen den Enden einer jeden Frontplatten und dem Rahmen des Baugruppenträgers über dessen Querschienen herstellbar. Doch sind diese Verbindungen nur punktuell und erstrekken sich nicht über die gesamte Breite der jeweiligen Frontplatte. Insbesondere bei breiten Frontplatten von Flachbaugruppen, welche das Volumen von mehr als einem Standardeinbauplatz im Inneren des Baugruppenträgers einnehmen, ist eine derartige punktuelle elektrisch leitende Verbindung zwischen der Frontplatte und den an deren Enden dahinter verlaufenden Querschienen des Baugruppenträgers für eine sichere elektromagnetische Abschirmung nicht ausreichend.

Das gleiche Problem tritt auch bei Abdeckplatten z.B. auf der Rückseite von Baugruppenträgern auf. Auch diese werden in der Regel nur punktuell über Schrauben mit den an der Ober- und Unterseite der Rückseite des Baugruppenträgers verlaufenden Querschienen verbunden.

Hierzu ist aus der nicht vorveröffentlichten DE 195 23 257 C1, die der EP-A-0 756 445 entspricht, die unter Art. 54(3) EPÜ fällt, ein Baugruppenträger bekannt, bei der die metallischen oder metallisierten Frontplatten der Baugruppen über Blattfedern mit den vorderen Profilschienen leitend verbunden sind. Eine Blattfeder weist dabei ein Fixierteil auf, der an einem eine Nut bildenden Schenkel der Profilschiene befestigt ist. Die Blattfeder selbst weist federnde Teile auf, womit der elektrische Kontakt mit der Frontplatte und der Profilschiene im eingeschobenem Zustand hergestellt wird.

Aus der DE 296 18 625 U1 ist ein weiterer abgeschirmter Baugruppenträger bekannt. Deren Modulschienen weisen hinter ihrer Anlageflächen je eine obere und untere Eingriffsnut auf. Es sind auf die Anlageflächen aufschnappbare Kontaktfederbänder vorgesehen, welche durch Hintergreifen der Anlageflächen in die Eingriffsnuten elastisch einrasten. Die Kontaktfederbänder weisen eine Anzahl von federnd zur Vorderseite des Baugruppenträgers weisenden Ausbrechungen sowie eine Anzahl von zur Anlagefläche weisenden Kontaktkrallen auf.

Bei den Kontaktfederbändern der bekannten abgeschirmten Baugruppenträger sind möglicherweise verschleißbedingte Beschädigungen insbesondere dann nicht vollständig vermeidbar, wenn Preßkräfte auf die Kontaktfedern der Federbänder ausgeübt werden, welche nicht nur von der Anlage von Frontplatten herrühren. Insbesondere dann, wenn an den längsseitigen Enden der Frontplatten von Baugruppen Griffhebel angebracht sind, womit die dazugehörige Baugruppe aus dem Baugruppenträger zumindest aushebelbar ist, können punktuell erhebliche Biegekräfte auf die Kontaktfederbänder ausgeübt werden.

Der Erfindung liegt die Aufgabe zugrunde, einen Baugruppenträger so weiterzubilden, daß die elektromagnetische Kontaktierung von flächigen Elementen, wie insbesondere Frontplatten von eingeschobenen Flachbaugruppen und rückseitigen Abdeckplatten mit den unteren und oberen Querschienen an der Front- und/oder Rückseite des Baugruppenträgers auch dann gewährleistet ist, wenn die eingesetzten Kontaktfederleisten nicht immer nur großflächig, über die Innenflächen von Frontplatten ausgeübten Preßkräften belastet werden.

Die Aufgabe wird gelöst mit dem im Anspruch 1 angegebenen Baugruppenträger. Weitere, vorteilhafte Ausführungsformen der Erfindung sind in den Unteransprüchen angegeben.

Die Erfindung wird an Hand von in den nachfolgend kurz angeführten Figuren dargestellten Ausführungsbeispielen näher erläutert. Dabei zeigt
- FIG 1 :: eine Schnittdarstellung durch einen beispielhaften Baugruppenträger mit einer ersten Ausführung eines Frontelements für eine Flachbaugruppe und einer gemäß der Erfindung gestalteten elektromagnetischen Abschirmung der Enden des Frontelements im Bereich der Querschienen,
- FIG 2 :: eine Draufsicht auf das beispielhafte Frontelement gemäß der Ausführung von Figur 1,
- FIG 3 :: eine Seitenansicht auf eine zweite Ausführung eines Frontelements einer Flachbaugruppe, welches bei dem erfindungsgemäßen Baugruppenträger einsetzbar ist,
- FIG 4 :: eine Schnittdarstellung durch eine bevorzugte Ausführung einer Kontaktfederleiste gemäß der Erfindung,
- FIG 5 :: eine Schnittdarstellung durch einen erfindungsgemäßen Baugruppenträger im Bereich der unteren Querschiene,
- FIG 6 :: eine perspektivische Draufsicht auf die untere Querschiene eines erfindungsgemäßen Baugruppenträgers gemäß der Ausführung von Figur 5, und
- FIG 7 :: eine perspektivische Draufsicht auf einen Ausschnitt der bevorzugten Ausführungsform für eine erfindungsgemäße Kontaktfederleiste gemäß Figur 7.
- FIG 8a :: eine Seitenansicht auf einen Baugruppenträger im Bereich der unteren Querschiene, wobei am unteren Ende des Frontelements ein Griffhebel angebracht ist, und die dazugehörigen Baugruppe vollständig in den Baugruppenträger eingeschoben ist,
- FIG 8b :: :eine der Darstellung von FIG 8a entsprechende Seitenansicht, wobei die dazugehörige elektrische Flachbaugruppen durch eine Betätigung des Griffhebels bereits zumindest teilweise aus dem Baugruppenträger ausgehebelt ist,
- FIG 8c :: eine der Darstellung von FIG 8a, 8b entsprechende Seitenansicht, wobei die dazugehörige elektrische Flachbaugruppen durch eine Betätigung des Griffhebels vollständig aus dem Baugruppenträger ausgehebelt ist.

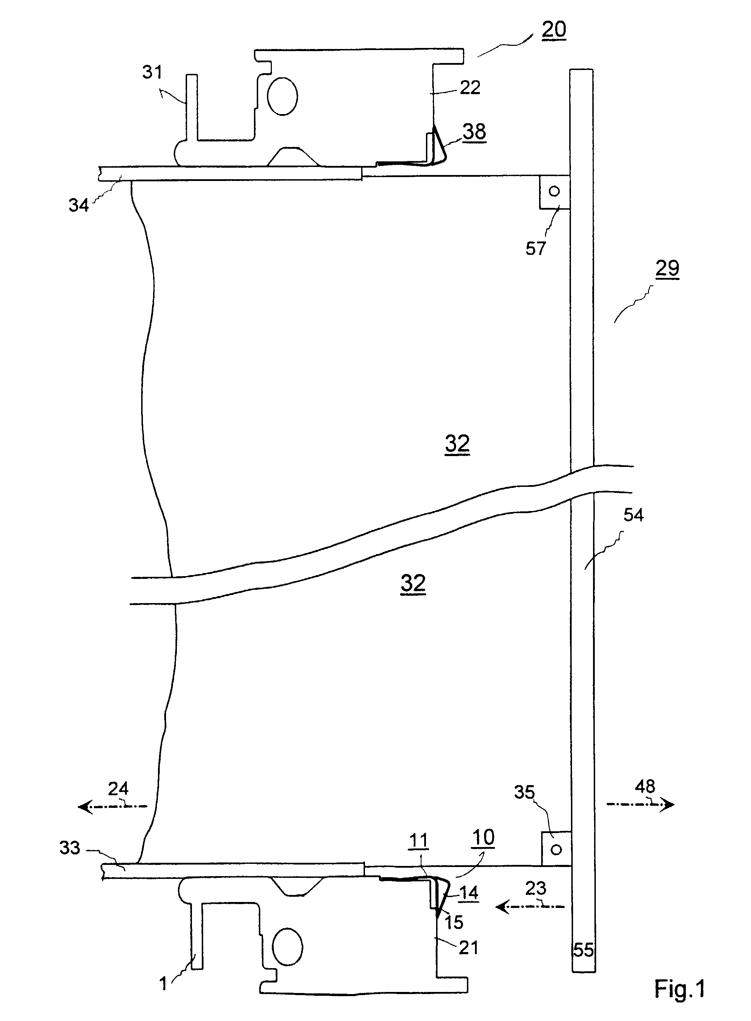

Figur 1 zeigt eine Schnittdarstellung durch einen beispielhaften Baugruppenträger im Bereich von dessen Frontseite 20, welcher zur Halterung von insbesondere vertikal nebeneinander einschiebbaren elektrischen Flachbaugruppen dient. Es handelt sich dabei in der Regel um Leiterplatten, welche mit elektrischen Bauelementen bestückt sind. Der Baugruppenträger weist eine untere Querschiene 1 auf, welche beispielhaft am unteren Ende der Frontseite 20 des Baugruppenträgers angeordnet ist. Eine entsprechende obere Querschiene 31 befindet sich am oberen Ende der Frontseite 20. Diese Querschienen sind aus elektrisch leitenden Material gefertigt, bzw. zumindest mit einem derartigen überzogen. Zwischen den Querschienen sind elektrische Flachbaugruppen bevorzugt senkrecht nebeneinander stehend in den Baugruppenträger einschiebbar.

Ferner kennen entsprechende Querschienen auch an der in Figur 1 nicht dargestellten Rückseite des Baugruppenträgers und zusätzlich entsprechende Querschienen auch in Form von sogenannten horizontalen Mittelquerschienen innerhalb der Frontund Rückseite eines Baugruppenträgers angeordnet sein. Hiermit kann die gesamte Bauhöhe des Baugruppenträgers verkürzt werden, so daß auch Leiterplatten mit einer geringeren Einschubhöhe in den Baugruppenträger einschiebbar sind.

In Figur 1 ist beispielhaft das Frontelement 29 einer in den Baugruppenträger bereits teilweise eingeschobenen Flachbaugruppe 32 in einer Seitenansicht gezeigt. Dieses ist ebenfalls aus elektrisch leitenden Material gefertigt, bzw. zumindest mit einem derartigen überzogen. In der dargestellten Ausführung weist das Frontelement 29 eine Frontplatte 54 auf, welche über je ein Eckmontagestück 35, 57 mit der Flachbaugruppe 32 verbunden ist. Ein Pfeil 24 in strichlierter Linie zeigt die Richtung des Einfahrweges bzw. der Pfeil 48 die Richtung des Ausfahrweges der elektrischen Flachbaugruppe 32 in den Baugruppenträger an. Jeweils auf der Seite einer jeden Querschiene 1, 31, welche der Innenseite des Baugruppenträgers zugewandten ist, ist eine Führungsschiene 33, 34 in Einfahrrichtung 24 angebracht. Diese weisen Nuten auf, in welchen die Kanten der Flachbaugruppe 32 zum Ein- und Ausfahren entlang gleiten können.

Erfindungsgemäß ist nun mindestens eine Kontaktfederleiste vorgesehen. Im Beispiel der Figur 1 ist eine untere Kontaktfederleiste 10 und eine entsprechend aufgebaute obere Kontaktfederleiste 38 vorgesehen. Der Aufbau einer Kontaktfederleiste gemäß der Erfindung wird nachfolgend am Beispiel der unteren Kontaktfederleiste 10 von Figur 1 erläutert. Diese weist Haltemittel 11 auf, welche zur Anbringung der Kontaktfederleiste 10 an einer, der Frontseite 20 des Baugruppenträgers zugewandten Stirnseite 21 einer unteren Querschiene 1 dienen. Die Kontaktfederleiste 10 und die untere Querschiene 1 sind dabei elektrisch leitend kontaktiert. Eine entsprechende Kontaktfederleiste 38 ist an der Stirnseite 22 der oberen Querschiene 31 angebracht, welche ebenfalls der Frontseite 20 des Baugruppenträgers zugewandt ist.

Erfindungsgemäß weist die Kontaktfederleiste 10 mindestens eine Kontaktfeder 14 auf. Diese ist mit den Haltemitteln 11 derart verbunden und weist in Richtung auf die Außenseite 20 des Baugruppenträgers derart abgespreizte Federschenkel 15 auf, daß die Federschenkel 15 sich annähernd in Richtung der bevorzugt senkrecht verlaufenden Längsseite 55 des Frontelements 29 der Flachbaugruppe 32 erstrecken und die Federwege 23 der Federschenkel 15 annähernd in Richtung zum Ein- und Ausfahrweg 24 und 48 der Flachbaugruppe 32 in den und aus dem Baugruppenträger verlaufen.

In vollständig eingeschobenem Zustand liegt die elektrische Flachbaugruppe 32 auf den Stirnseiten 21,22 der unteren und oberen Querschiene 1,31 auf. Auf diese Weise können die Frontelemente von nebeneinander liegend in den Baugruppenträger eingeschobenen elektrischen Flachbaugruppen unterbrechungsfrei über die gesamte Breite mit der jeweils dahinter liegenden Querschiene elektrisch leitend kontaktiert werden. Hierdurch kann eine elektromagnetischen Abschirmung eines Baugruppenträgers auch im Bereich der Enden eines Frontelements an den Querschienen erreicht werden.

Die Ausführung dieser Abschirmung mit den Kontaktfederleisten gemäß der Erfindung hat den Vorteil, daß auf Grund der vorteilhaften Abspreizung der Federschenkel auch dann keine Beschädigung bzw. Zerstörung derselben zu befürchten ist, wenn nicht nur Flächenpresskräfte von den Innenseiten der Frontplatte 54 des Frontelements 29 der Flachbaugruppe 32 auftreten. Vielmehr kann eine derartige Kontaktfederleiste auch Preßkräfte dauerhaft kompensieren, welche z.B. bei der Aushebelung der Flachbaugruppe mit Hilfe von Griffhebeln auftreten, die sich auf den Stirnseiten 21, 22 der Querschienen 1,31 abstützen. Dies wird nachfolgend noch weiter erläutert werden.

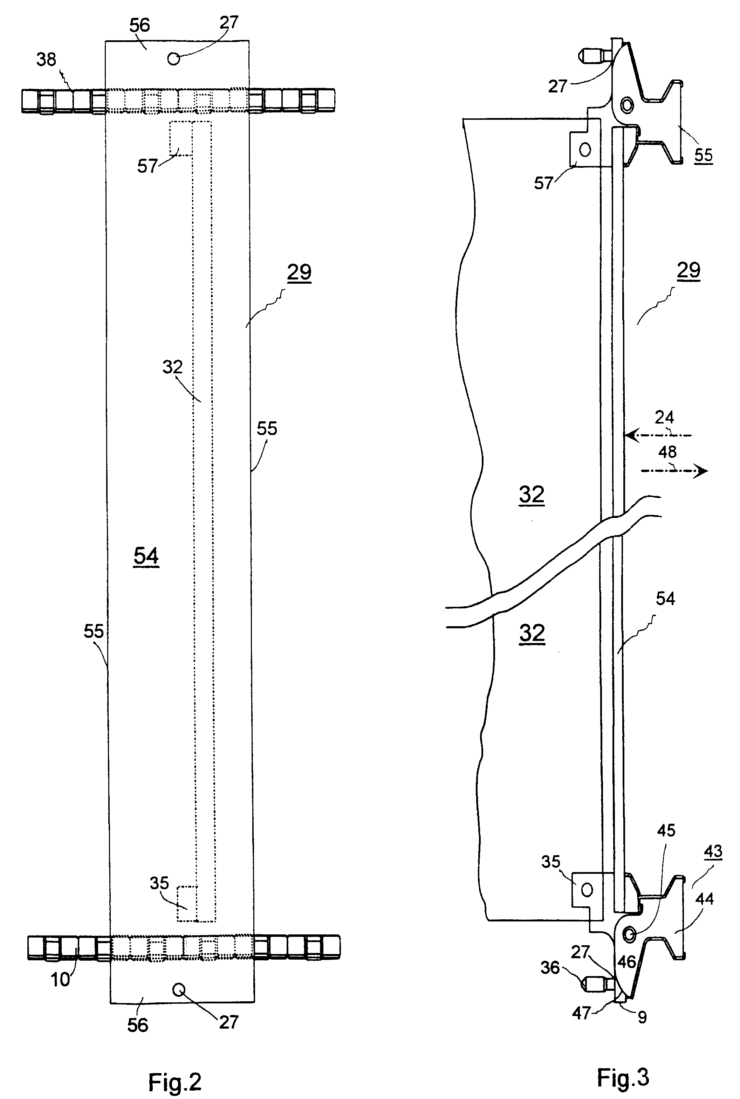

FIG 2 zeigt eine Draufsicht auf das beispielhafte Frontelement 29 gemäß der Ausführung von Figur 1. Wie bereits ausgeführt, enthält dieses eine langgestreckte Frontplatte 54 mit zwei bevorzugt senkrecht verlaufenden Längsseiten 55 und zwei kurzen, parallel zu den Querschienen 1, 31 verlaufenden Querseiten 56. Das Frontelement umfaßt ferner je ein unteres und oberes Eckmontagestück 35, 57, welches sowohl mit Innenseite der Frontplatte 54, als auch mit den Ecken der elektrischen Flachbaugruppe 32 verbunden sind. In Figur 2 sind diese hinter der Frontplatte 54 liegenden Teile punktiert dargestellt. Schließlich sind Ausschnitte der oberen und unteren Kontaktfederleiste 10, 38 sichtbar, welche auf den Stirnseiten der nicht mehr dargestellten Querschienen aufliegen. Die auf der Hinterseite der Frontplatte 54 kontaktierenden Teile der Kontaktfederleisten sind wiederum punktiert dargestellt.

FIG 3 zeigt eine Seitenansicht auf eine zweite Ausführungsform eines Frontelements 29 für eine Flachbaugruppe 32, welches bei dem erfindungsgemäßen Baugruppenträger einsetzbar ist. Dieses enthält zusätzlich Griffhebel 44, 55, welche im Bereich der kurzen Querseiten 56 an den Längsseiten Enden 9 der Frontplatte 54 angeordnet sind. Bei der dargestellten Ausführung sind die Eckmontagestücke 35, 57 so gestaltet, daß sie auch zur Halterung der Griffhebel 44, 55 dienen, welche über Lagerzapfen 45 darin drehbar gelagert sind. Die Eckmontagestücke weisen ferner Bohrungen 27 auf, in die Halteschrauben 36 eingelegt sind.

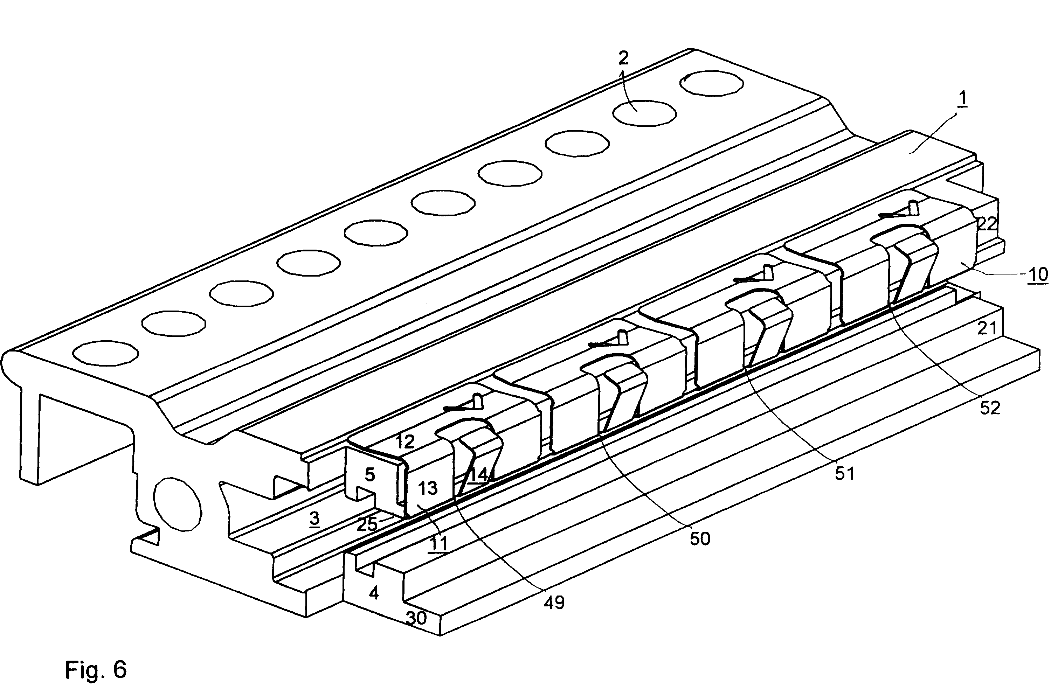

Die Griffhebel in Figur 3 weisen zumindest ein Griffstück 44 auf, welches von einer Person bedienbar ist und einen Abstützschenkel 46 auf der anderen Seite des Drehpunktes 45. Auf der dem Baugruppenträger zugewandten Innenseite verfügen die Abstützschenkel 46 über mindestens eine gekrümmte Abdrückfläche 47. Wird z.B. der untere Griffhebel 44 zum Zwecke einer Aushebelung der Flachbaugruppe 32 aus dem Baugruppenträger nach unten gedrückt, so stützt sich der Abdrückschenkel 46 auf der dahinterliegenden Querschiene und der darauf befindlichen Kontaktfederleiste 10 ab. Auf Grund der erfindungsgemäßen, vorteilhaften Gestaltung der Kontaktfederleiste 10 kann die Abdrückfläche 47 auf der Kontaktfederleiste abrollen, ohne daß diese dabei beschädigt wird. Die Kontaktleiste liegt dabei im eingeschobenen Zustand der Flachbaugruppe elektrisch leitend auf der Innenseite des jeweiligen Eckmontagestückes 35, 57 an. Dies wird nachfolgend insbesondere an Hand der Figuren 6a, 6b und 6c noch näher erläutert.

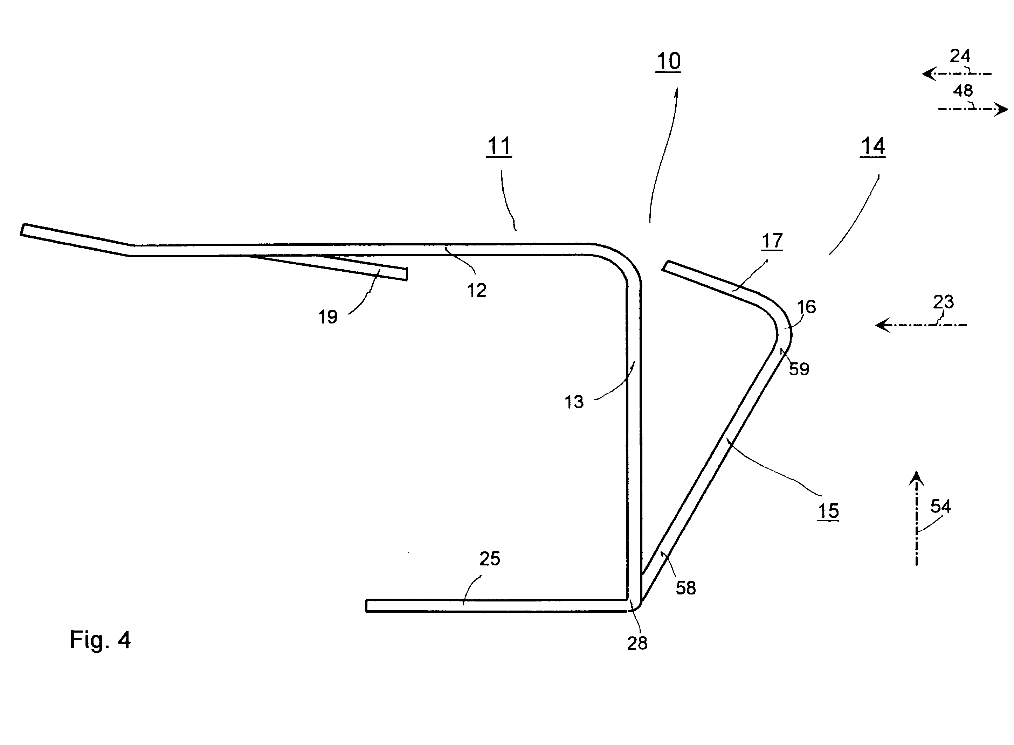

FIG 4 zeigt eine Schnittdarstellung durch eine bevorzugte Ausführung einer Kontaktfederleiste 10 gemäß der Erfindung, welche aus mindestens einem Haltemitteln 11 und aus mindestens einer Kontaktfeder 14 besteht. Erfindungsgemäß erstrekken sich die Federschenkel 15 annähernd in Richtung der bevorzugt senkrecht verlaufenden Längsseite 54 des Frontelements einer Flachbaugruppe. Dies ist in Figur 4 durch einen strichpunktierten Pfeil mit dem Bezugszeichen 54 symbolisiert. Erfindungsgemäß verläuft der Federweg 23 des in Figur 4 dargestellten Federschenkels 15 annähernd in Richtung zum Ein- und Ausfahrweg 24, 48 von Flachbaugruppen in den und aus dem Baugruppenträger. Der Federweg 23 und der Ein- und Ausfahrweg 24, 48 sind in Figur 4 ebenfalls durch entsprechende strichpunktierte Pfeile dargestellt.

Die in Figur 4 dargestellte, bevorzugte Ausführungsform für einen Federschenkel 15 gemäß der Erfindung weist zudem auf ein erstes, der Querschiene des Baugruppenträgers, an denen die Haltemittel angebracht sind, zugewandtes Schenkelende 58. Dieses Schenkelende ist von den Haltemitteln 11 an einer Längskante 28 abgewinkelt. Diese verläuft annähernd parallel zur kurzen Querseite 55 eines Frontelementes 29, bzw. annähernd parallel zu der mit den Haltemitteln 11 verbundenen Querschiene, z.B. der Querschiene 1 in Figur 1. Die in Figur 4 dargestellte, bevorzugte Ausführungsform des Federschenkels 15 enthält weiterhin ein zweites, von der Querschiene 1 abgespreiztes Schenkelende 59, welches in einen bevorzugt gekrümmten Kontaktbereich 16 mündet. Dieses liegt im eingeschobenen Zustand einer Leiterplatte elektrisch leitend an der Innenseite des Frontelements 29 einer Flachbaugruppe 32 an. Vorteilhaft weist ein Federschenkel 15 zusätzlich eine Kontaktbereichsverlängerung 17 auf, welche von dem zweiten, abgespreizten Schenkelende 59 in Richtung auf eine Querschiene des Baugruppenträgers abgewinkelt ist, z.B. der Querschiene 1 in Figur 1.

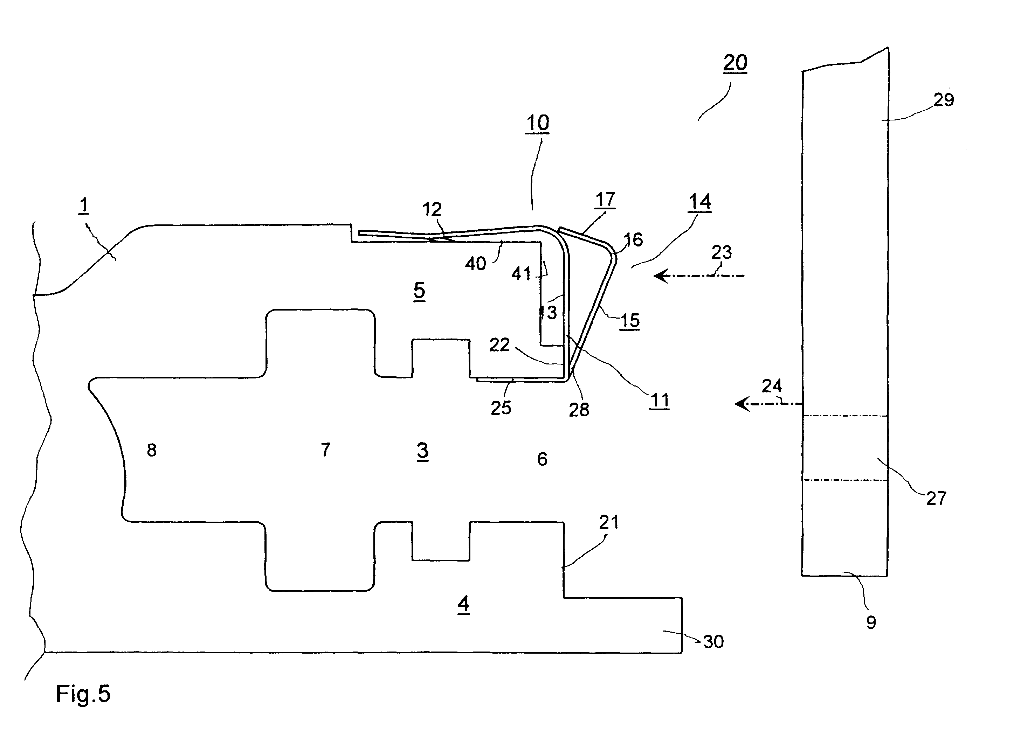

Bevorzugt sind die Haltemittel 11 der Kontaktfederleiste jeweils u-förmige gestaltet und somit vorteilhaft auf einer der Frontseite 20 des Baugruppenträgers zugewandten Stirnseite einer Querschiene aufsteckbar. Dies wird nachfolgend am Beispiel der Figur 5 noch näher erläutert werden. Bei der in Figur 4 dargestellten, vorteilhaften Ausführung einer Kontaktfederleiste 10 weist die u-förmige Halteleiste 11 zumindest eine Auflageleiste 25 mit einer Längskante 28 auf, von der die Federschenkel 15 der Kontaktfedern 14 bevorzugt an dem einen Schenkelende 28 abgespreizt sind. Zumindest über die Auflageleiste 25, welche in Richtung der jeweiligen Querschiene des Baugruppenträgers verläuft, ist die Kontaktfederleiste mit der entsprechenden Querschiene z.B. durch eine Verklebung verbunden.

Gemäß einer weiteren, in der Figur 4 bereits dargestellten Ausführungsform der Erfindung ist es für den Fall, daß die Verbindung von Haltemitteln und Querschiene ausschließlich auf mechanischem Wege, z.B. durch Verklemmung, erfolgt vorteilhaft, wenn zusätzlich zumindest ein Verbindungssteg annähernd rechtwinkelig von der Auflageleiste 25 abgewinkelt ist. Der Verbindungssteg liegt dann auf einer der Frontseite 20 des Baugruppenträgers zugewandten Stirnseite 21 der entsprechenden Querschiene 1 an. Zumindest ein zusätzliches Klemmblatt 12 ist von dem Verbindungssteg 13 wiederum annähernd rechtwinkelig abgewinkelt, welches die Querschiene umfaßt.

Figur 5 zeigt eine Schnittdarstellung durch einen erfindungsgemäßen Baugruppenträger im Bereich der unteren Querschiene 1. Bei dem dargestellten Beispiel enthält die untere Querschiene 1 eine quer verlaufende, zur Frontseite 20 des Baugruppenträgers geöffnete Aufnahmenut 3. In diese können Halteelemente für das Frontelement 29 einer Flachbaugruppe eingreifen, z.B. die im Beispiel der Figur 3 dargestellte Montageschraube 36, welche durch eine entsprechende Bohrung 27 im Frontelement 29 hindurchführbar ist. Vorteilhaft besteht die Aufnahmenut im Querschnitt aus einem vorderen, verengten Einführungsbereich 6, welcher sich zur Frontseite 20 des Baugruppenträgers öffnet. In Richtung auf den Nutgrund schließt sich ein mittlerer, erweiterter Aufnahmebereich 7 an, in welchen z.B. eine Gewindelochschiene einschiebbar ist. Zur besseren Übersicht ist eine Gewindelochschiene in Figur 5 nicht dargestellt. Die Aufnahmenut 3 endet beispielhaft in einem hinteren, verengten Ausgleichsbereich 8, welcher zur Aufnahme des Endes der Gewindebolzen von vollständig eingeschraubten Montageschrauben dient.

Bei dem in Figur 5 dargestellten Beispiel wird die quer verlaufende Aufnahmenut 3 somit durch eine untere und eine obere Begrenzungsleiste 4 und 5 begrenzt. Nach einer vollständigen Einschiebung der Flachbaugruppe in Richtung des Pfeiles 24 in den Baugruppenträger liegt das Frontelement 29 somit an den Stirnseiten 21, 22 der unteren und oberen Begrenzungsleiste 4, 5 der quer verlaufenden Aufnahmenut 3 an. Bei dem in Figur 5 dargestellten Beispiel sind die bevorzugt u- förmig gestalteten Haltemittel 11 der Kontaktfederleiste 10 vorteilhaft auf der Stirnseite 22 derjenigen Begrenzungsleiste 5 der quer verlaufenden Aufnahmenut 3 der unteren Querschiene 1 aufgesteckt, welche der Innenseite des Baugruppenträgers zugewandt ist. Die Kontaktfeder 14 wird somit entlang der Biegelinie 28 in Richtung auf die Stirnseite 22 der Begrenzungsleiste 5 gedrückt, was in Figur 5 durch den strichpunktierten Pfeil 23 symbolisiert ist. Zur Verbesserung der Kontaktierung ist es vorteilhaft, wenn die Stirnseite 22 nicht durchgängig ist, sondern hinter dem Kontaktbereich 16 des Federschenkels 15 eine zurückgesetzte Senkungsfläche 41 aufweist. Der Federschenkel 15 kann dann von der Innenseite des Frontelementes 29 so weit eingedrückt werden, daß auch ein elektrisch leitender Kontakt der in Figur 5 senkrecht stehenden Verbindungsstege 13 mit den Innenseiten des Frontelements 29 eintritt. Schließlich ist es zur Verbesserung der Klemmwirkung und der Haltestabilität vorteilhaft, wenn auch auf der der Innenseite des Baugruppenträgers zugewandten Oberfläche der Begrenzungsleiste 5 eine Senkungsfläche 40 vorhanden ist, auf der sich das Klemmblatt 12 der u-förmigen Haltemittel 10 mittel einer Reibverbindung abstützt.

In Figur 6 ist eine perspektivische Draufsicht auf die untere Querschiene eines erfindungsgemäßen Baugruppenträgers gemäß der Ausführung von Figur 5 dargestellt. Erfindungsgemäß sind die Kontaktfedern 14 der Kontaktfederleiste 10 derart gestaltet, daß deren Federwege annähernd parallel zum Einschubweg von elektrischen Flachbaugruppen in den Baugruppenträger verlaufen. Dabei verläuft der auf die Stirnseite 22 der oberen Begrenzungsleiste 5 gerichtete Federweg der Kontaktfedern 14 annähernd parallel zu dem Einschubweg von elektrischen Flachbaugruppen in den Baugruppenträger. Diese Ausführung hat den besonderen Vorteil, daß beim Aufschieben der Frontelemente auf die Kontaktfederleiste 10 keinerlei Querkräfte ausgeübt werden. Vielmehr wird die Kontaktfederleiste 10 lediglich mit Kräften belastet, welche orthogonal auf den Leistenkörper und die darunter befindliche Stirnseite 22 der oberen Begrenzungsleiste 5 gerichtet sind. Hierdurch kann das Auftreten von irreversiblen Verbiegungen der Kontaktfedern 14 und insbesondere deren Federschenkeln 14 vermieden werden.

Gemäß einer weiteren Ausführung der Erfindung ist die Kontaktfederleiste 10 in Figur 6 aus einzelnen, identisch aufgebauten Federsegmenten gebildet. Dabei sind in Figur 6 ausschnittsweise die vier Federsegmente 49, 50, 51 und 52 beispielhaft dargestellt. Jedes Federsegment weist dabei zumindest ein Haltemittel 11 und eine Kontaktfeder 14 auf. Die Haltemittel sind bevorzugt u-förmig ausgebildet und bestehen aus je einer Auflageleiste 25, einem vertikalen Verbindungssteg 13 und einem Klemmblatt 12. Die Elemente 25, 13 und 12 sind annähernd rechtwinkelig miteinander verbunden. Gemäß einer weiteren, in Figur 6 bereits dargestellten Ausführung bilden die zu abgespreizten Kontaktfedern 14 gehörigen Auflageleisten 25 eine einteilige, durchgehende Leiste, welche entlang der gesamten Länge der Querschiene 1 auf der Innenseite der oberen Begrenzungsleiste 5 aufliegt.

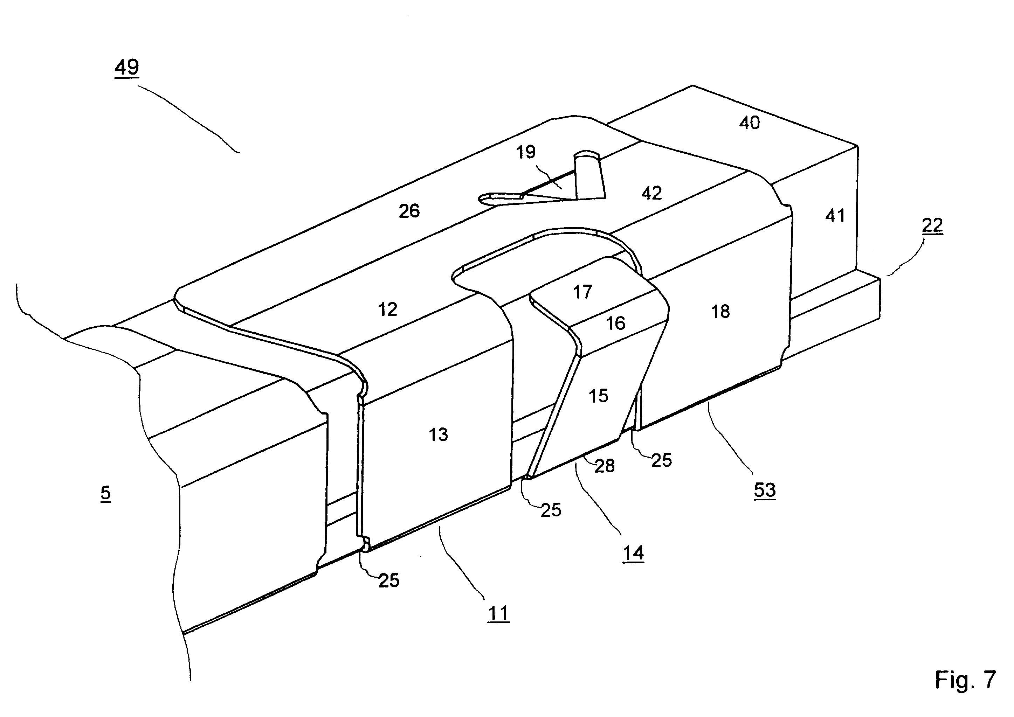

Figur 7 zeigt eine perspektivische Draufsicht auf einen Ausschnitt der bevorzugten Ausführungsform für eine erfindungsgemäße Kontaktfederleiste gemäß Figur 6. Im Beispiel der Figur 7 liegt die bevorzugt durchgehende Auflageleiste 25 auf der der Aufnahmenut 3 zugewandten Innenfläche der oberen Begrenzungsleiste 5 an. Von der Auflageleiste 25 sind annähernd rechtwinkelig Verbindungsstege abgewinkelt. In der Seitenansicht der Figur 7 sind diese mit den Bezugszeichen 13 und 18 versehen, und liegen auf der Stirnseite 22 der oberen Begrenzungsleiste 5 auf. Von den Verbindungsstegen 13, 18 sind wiederum annähernd rechtwinkelig Klemmblätter 12 abgewinkelt, welche in Figur 7 auf der Außenfläche der oberen Begrenzungsleiste 5 aufliegen. Durch die Auflageleiste 25, die Verbindungsstege 13, 18 und die Klemmblätter 12 wird somit ein u-förmiger Klemmbereich gebildet. Vorteilhaft sind dabei die Kontaktfedern 14 an der Knickkante zwischen der durchgehenden Auflageleiste 25 und den Verbindungsstegen 13, 18 in Richtung auf die Front- bzw. Rückseite 20 des Baugruppenträgers abgespreizt.

Im Beispiel der Figur 7 sind dem dort dargestellten Kontaktfedersegment 49 vorteilhaft jeweils zwei benachbarte Verbindungsstege 13,18 zugeordnet und über einen Quersteg 26 u-förmig miteinander verbunden. Jeweils eine Kontaktfeder 14 ist in dem Raum zwischen den verbundenen Verbindungsstegen angeordnet. Die federnde Knickkante 28 zwischen einem Federschenkel 15 und der bevorzugt durchgehenden Auflageleiste 25 liegt dem überbrückenden Quersteg 26 bevorzugt gegenüber. Eine Kontaktfeder 14 besteht wiederum vorteilhaft aus einem von der Auflageleiste 25 abgespreizten Federschenkel 15, welcher zur Bildung einer ausreichenden Kontaktfläche 16 in eine abgewinkelte Kontaktbereichsverlängerung 17 übergeht. Diese kommt bei einer Verspannung der Kontaktfeder durch eine aufliegende Frontplatte im Bereich zwischen zwei benachbarten, über einen Quersteg 26 verbundenen Verbindungsstegen 13,18 zu liegen.

In Figur 7 sind ebenfalls die bereits am Beispiel der Figur 5 erläuterten, zum Eingriff der Kontaktfeder 14 dienende zweite Senkungsfläche 41 an der Stirnseite 22 der oberen Begrenzungsleiste 5 und die zur Auflage des Klemmblattes 12 dienende erste Senkungsfläche 40 auf der Oberseite der oberen Begrenzungsleiste 5 dargestellt. Vorteilhaft sind aus der Wandung eines Klemmblattes 42 bzw. des Quersteges 26 zackenförmige Rastelemente 19 freigestanzt und in Richtung auf die Oberseite der oberen Begrenzungsleiste 5 eingedrückt. Hiermit kann die Klemmwirkung zwischen dem bevorzugt u-förmigen Halteelement 10 und der davon umfaßten oberen Begrenzungsleiste 5 verbessert werden.

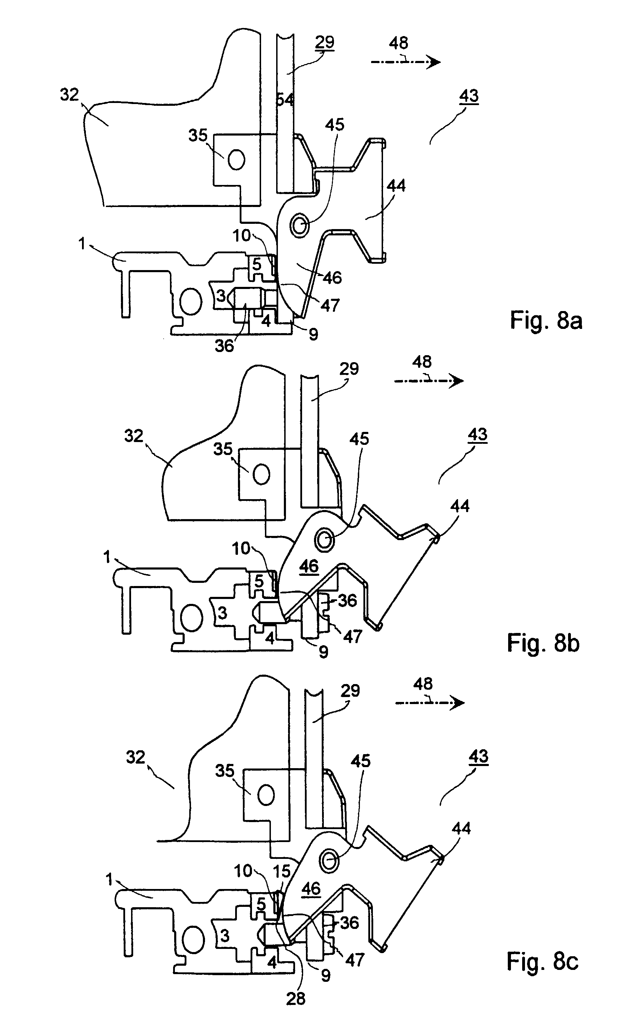

Schließlich zeigt Figur 8a eine Seitenansicht auf einen Baugruppenträger im Bereich der unteren Querschiene 1, wobei die dazugehörige Flachbaugruppe 29 vollständig in den Baugruppenträger eingeschoben ist. Im dargestellten Beispiel weist das Frontelements 29 der Flachbaugruppe 32 am unteren Ende 9 einen Griffhebel 43, durch dessen Betätigung die Flachbaugruppe 32 zumindest aus dem Baugruppenträger aushebelbar ist. Der Griffhebel 43 weist zumindest ein Griffstück 44 auf, womit über einen durch einen Lagerzapfen 45 gebildeter Drehpunkt ein Abstützschenkel 46 geschwenkt werden kann. Der Griffhebel 43 und die Frontplatte 54 des Frontelements 29 sind über ein Eckmontagestück 35 miteinander verbunden. Bei dem in Figur 8a dargestellten, vollständig eingeschobenen Zustand der Flachbaugruppe 32 liegt beispielsweise die Innenseite des Eckmontagestückes 35 des Frontelementes 29 elektrisch leitend auf der Kontaktfederleiste 10 auf. Erfindungsgemäß weist der Griffhebel 43 zumindest eine gekrümmte Abdrückfläche 47 auf, welche sich bei einer, eine Aushebelung der Flachbaugruppe 32 aus dem Baugruppenträger bewirkenden Betätigung des Griffhebels 43 auf der unteren Querschiene 1 und der daran angebrachten Kontaktfederleiste 10 abstützt und darauf abrollt.

Figur 8b zeigt eine der Figur 8a entsprechende Seitenansicht, wobei die elektrische Flachbaugruppen 29 durch eine Betätigung des Griffhebels 43 bereits zumindest teilweise aus dem Baugruppenträger ausgehebelt ist. Hierzu wurde der Hebel nach unten gedrückt und nimmt die in Figur 8b gezeigte, geschenkte Position ein. Durch die Abstützung und Abrollung der Abdrückfläche 47 wurde die elektrische Flachbaugruppe 32 in Richtung des strichpunktierten Pfeiles 48 aus dem Baugruppenträger bewegt. Auf Grund der besonders vorteilhaften Gestaltung der Kontaktfederleiste 10 des erfindungsgemäßen Baugruppenträgers wird diese durch einen derartigen Aushebelvorgang in keiner Weise verformt oder sogar beschädigt. Figur 8c zeigt schließlich eine der Darstellungen der Figuren 8b, 8c entsprechende Seitenansicht, wobei die dazugehörige elektrische Flachbaugruppen durch die Betätigung des Griffhebels nun vollständig aus dem Baugruppenträger ausgehebelt ist. Dabei hat der Federschenkel 15 der Kontaktfeder 14 wieder den unbelasteten, vollständig abgespreizten Zustand angenommen

## Patentansprüche

1. Baugruppenträger zur Halterung von insbesondere vertikal nebeneinander einschiebbaren elektrischen Flachbaugruppen (32), mit
a) elektrisch leitenden Querschienen (1,31) zumindest an der Frontseite (20) des Baugruppenträgers, zwischen denen die Flachbaugruppen (32) einschiebbar sind,
b) jeweils einem, einer Flachbaugruppe (32) zugeordneten, elektrisch leitenden Frontelement (29), und mit
c) mindestens einer Kontaktfederleiste (10;38), die aufweist
c1) Haltemittel (11) zur Anbringung der Kontaktfederleiste (10;38) an einer, der Frontseite (20) des Baugruppenträgers zugewandten Stirnseite (21,22) einer Querschiene (1,31), und
c2) Kontaktfedern (14), welche mit den Haltemitteln (11) derart verbunden sind und in Richtung auf die Außenseite (20) des Baugruppenträgers derart abgespreizte Federschenkel (15) aufweisen, daß
c21) die Federschenkel (15) sich annähernd in Richtung der bevorzugt senkrecht verlaufenden Längsseite (54) des Frontelements (29) einer Flachbaugruppe (32) erstrecken, und
c22) die Federwege (23) der Federschenkel (15) annähernd in Richtung zum Ein- und Ausfahrweg (24,48) von Flachbaugruppen (32) in den und aus dem Baugruppenträger verlaufen.

2. Baugruppenträger nach Anspruch 1, wobei ein Federschenkel (15) aufweist
a) ein erstes, der Querschiene (1) zugewandtes Schenkelende (58), welches von den Haltemitteln (11) an einer Längskante (28) abgewinkelt ist, die annähernd parallel zur kurzen Querseite (55) eines Frontelementes (29) verläuft, und
b) ein zweites, von der Querschiene (1) abgespreiztes Schenkelende (59), welches in einen bevorzugt gekrümmten Kontaktbereich (16) mit der Innenseite des Frontelements (19) einer Flachbaugruppe (32) mündet.

3. Baugruppenträger nach Anspruch 2, wobei ein Federschenkel (15) aufweist eine Kontaktbereichsverlängerung (17), welche von dem zweiten, abgespreizten Schenkelende (59) in Richtung auf die Querschiene (1,31) abgewinkelt ist.

4. Baugruppenträger nach einem der vorangegangenen Ansprüche, wobei die Haltemittel (11) der Kontaktfederleiste (10;38) jeweils u-förmige gestaltet und auf einer der Frontseite (20) des Baugruppenträgers zugewandten Stirnseite (21,22) einer Querschiene (1,31) aufsteckbar sind.

5. Baugruppenträger nach Anspruch 4, wobei
a) eine Querschiene (1,31) zumindest eine quer verlaufende Aufnahmenut (3) insbesondere zum Eingriff von Halteelementen (36) für die Frontelemente (29) von Flachbaugruppen aufweist, und
b) die u-förmigen Haltemittel (11) auf derjenigen Begrenzungsleiste (5;39) eine quer verlaufende Aufnahmenut (3,37) aufsteckbar sind, welche der Innenseite des Baugruppenträgers zugewandt ist.

6. Baugruppenträger nach Anspruch 4 oder 5, wobei die u-förmige Halteleiste (11) eine Auflageleiste (25) mit einer Längskante (28) aufweist, von der die Federschenkel (15) der Kontaktfedern (14) abgespreizt sind.

7. Baugruppenträger nach Anspruch 6, wobei
a) Verbindungsstege (13,18) annähernd rechtwinkelig von der Auflageleiste (25) abgewinkelt sind, welche auf der einer Frontseite (20) des Baugruppenträgers zugewandten Stirnseite (21,22) einer Querschiene (1,31) anliegen, und
b) Klemmblätter (12,42) von den Verbindungsstegen (13,18) wiederum annähernd rechtwinkelig abgewinkelt sind, welche die Querschiene (1) umfassen, insbesondere die obere Begrenzungsleiste (5;39) der quer verlaufenden Aufnahmenut (3;37) .

8. Baugruppenträger nach Anspruch 7, wobei die Kontaktfedern (14) an der Längskante (28) zwischen der Auflageleiste (25) und den Verbindungsstegen (13,18) in Richtung auf die Front-bzw. Rückseite (20) des Baugruppenträgers abgespreizt sind.

9. Baugruppenträger nach einem der Ansprüche 4 bis 8, wobei jeweils zwei u-förmig gestaltete Haltemittel (11) der Kontaktfederleiste (10;38) über einen Quersteg (26) miteinander verbunden sind, und eine Kontaktfeder (14) dazwischenliegend angeordnet ist.

10. Baugruppenträger nach Anspruch 7 oder 8, wobei jeweils zwei Klemmblätter (13,18) über einen Quersteg (26) miteinander verbunden sind, und eine Kontaktfeder (14) dazwischenliegend angeordnet ist.

11. Baugruppenträger nach einem der Ansprüche 6 bis 10, wobei die zu abgespreizten Federschenkeln (15) gehörigen Auflageleisten (25) eine einteilige, durchgehende Leiste bilden (Fig. 7).

12. Baugruppenträger nach einem der vorangegangenen Ansprüche, wobei
a) Griffhebel (43,55) an den Enden des Frontelements (29) einer Flachbaugruppe (32) angebracht sind, durch deren Betätigung die Flachbaugruppe (32) zumindest aus dem Baugruppenträger aushebelbar ist, und
b) die Griffhebel (43,55) zumindest eine gekrümmte Abdrückfläche (47) aufweisen, welche sich bei einer, eine Aushebelung der Flachbaugruppe (32) aus dem Baugruppenträger bewirkenden Betätigung des Griffhebels (43,55) auf der Kontaktfederleiste (10,28) abstützt und darauf abrollt.

## Claims

1. Mounting rack for holding electrical printed circuit board assemblies (32) which can be pushed in, in particular vertically, alongside one another having
a) electrically conductive transverse rails (1, 31) at least on the front face (20) of the mounting rack, between which the printed circuit board assemblies (32) can be inserted,
b) in each case one electrically conductive front element (29) which is allocated to a printed circuit board assembly (32), and having
c) at least one spring contact strip (10; 38) which has
c1) retaining means (11) for fitting the spring contact strip (10; 38) on an end face (21, 22), -facing the front face (20) of the mounting rack, of a transverse rail (1, 31), and
c2) contact springs (14) which are connected to the retaining means (11) and have spring limbs (15) which are spread apart in the direction of the outside (20) of the mounting rack, in such a manner that
c21) the spring limbs (15) extend approximately in the direction of the preferably vertically running longitudinal side (54) of the front element (29) of a printed circuit board assembly (32), and
c22) the spring movements (23) of the spring limbs (15) run approximately in the direction of the insertion and withdrawal movements (24, 48) of printed circuit board assemblies (32) into and out of the mounting rack.

2. Mounting rack according to Claim 1, a spring limb (15) having
a) a first limb end (58) which faces the transverse rail (1) and is bent by the retaining means (11) on a longitudinal edge (28) which runs approximately parallel to the short transverse side (55) of a front element (29), and
b) a second limb end (59) which is spread apart from the transverse rail (1) and opens into a preferably curved contact region (16) with the inside of the front element (19) of a printed circuit board assembly (32).

3. Mounting rack according to Claim 2, a spring limb (15) having a contact region extension (17) which is bent by the second, spread-apart limb end (59) in the direction of the transverse rail (1, 31).

4. Mounting rack according to one of the preceding claims, the retaining means (11) of the spring contact strip (10; 38) each being U-shaped in design and being capable of being plugged onto an end face (21, 22), facing the front face (20) of the mounting rack, of a transverse rail (1, 31).

5. Mounting rack according to Claim 4,
a) a transverse rail (1, 31) having at least one transversely running retaining groove (3) in particular for the engagement of retaining elements (36) for the front elements (29) of printed circuit board assemblies, and
b) the U-shaped retaining means (11) having a transversely running retaining groove (3, 37) on that boundary strip (5; 39) which faces the inside of the mounting rack.

6. Mounting rack according to Claim 4 or 5, the U-shaped retaining strip (11) having a bearing strip (25) with a longitudinal edge (28), by which the spring limbs (15) of the contact springs (14) are spread apart.

7. Mounting rack according to Claim 6,
a) connecting webs (13, 18) being bent approximately at right-angles from the bearing strip (25) and resting on the end face (21, 22), facing a front face (20) of the mounting rack of a transverse rail (1, 31), and
b) terminal leaves (12, 42) in turn being bent approximately at right-angles from the connecting webs (13, 18) and surrounding the transverse rail (1), in particular the upper boundary strip (5; 39) of the transversely running retaining groove (3; 37).

8. Mounting rack according to Claim 7, the contact springs (14) on the longitudinal edge (28) between the bearing strip (25) and the connecting webs (13, 18) being spread apart in the direction of the front face or rear face (20) of the mounting rack.

9. Mounting rack according to one of Claims 4 to 8, two retaining means (11), of U-shaped design, of the spring contact strip (10; 38) in each case being connected to one another via a transverse web (26), and a contact spring (14) being arranged in between them.

10. Mounting rack according to Claim 7 or 8, two terminal leaves (13, 18) in each case being connected to one another via a transverse web (26) and a contact spring (14) being arranged in between.

11. Mounting rack according to one of claims 6 to 10, the bearing strips (25) associated with the spread-apart spring limbs (15) forming an integral, continuous strip (Fig. 7).

12. Mounting rack according to one of the preceding claims,
a) gripping levers (43, 55) being fitted at the ends of the front element (29) of a printed circuit board assembly (32), whose operation allows the printed circuit board assembly (32) to be levered at least out of the mounting rack, and
b) the gripping levers (43, 55) having at least one curved pressure surface (47) which is supported on and rolls on the spring contact strip (10, 28) when the gripping lever (43, 55) is operated in order to lever the printed circuit board assembly (32) out of the mounting rack.

## Revendications

1. Châssis équipé pour maintenir des modules (32) plats qui peuvent y être insérés en étant notamment juxtaposés en position verticale, comportant
a) des rails (1, 31) transversaux électriquement conducteurs au moins sur le côté (20) avant du châssis équipé, entre lesquels les modules (32) plats peuvent être insérés,
b) un élément (29) avant électriquement conducteur respectif, associé à un module (32) plat, et comportant
c) au moins une baguette (10 ; 38) élastique de contact, qui comprend
c1) des moyens (11) de maintien pour installer la baguette (10 ; 38) élastique de contact sur un côté (21, 22) frontal d'un rail (1, 31) transversal qui est tourné vers le côté (20) avant du châssis équipé, et
c2) des ressorts (14) de contact, qui sont reliés aux moyens (11) de maintien de telle sorte, et comportent des branches (15) de ressort écartées en direction du côté (20) extérieur du châssis équipé de telle sorte, que
c21) les branches (15) de ressort s'étendent approximativement dans la direction du côté (55) longitudinal, s'étendant de préférence verticalement, de l'élément (29) avant d'un module (32) plat, et que
c22) les courses (23) élastiques des branches (15) de ressort s'étendent approximativement dans la direction de la course (24, 48) d'introduction et d'extraction des modules (32) plats dans et hors du châssis équipé.

2. Châssis équipé suivant la revendication 1, dans lequel une branche (15) de ressort comporte
a) une première (58) extrémité de branche, tournée vers le rail (1) transversal, qui est coudée à partir d'un bord (28) longitudinal des moyens (11) de maintien qui s'étend approximativement parallèlement au côté (56) transversal court d'un élément (29) avant, et
b) une deuxième (59) extrémité de branche, écartée du rail (1) transversal, qui débouche dans une région (16), de préférence cintrée, de contact avec le côté intérieur de l'élément (29) avant d'un module (32) plat.

3. Châssis équipé suivant la revendication 2, dans lequel une branche (15) de ressort comporte un prolongement (17) de la région de contact, qui est coudé en direction du rail (1, 31) transversal à partir de la deuxième (59) extrémité de branche, l'extrémité écartée.

4. Châssis équipé suivant l'une des revendications précédentes, dans lequel les moyens (11) de maintien de la baguette (10 ; 38) élastique de contact sont respectivement réalisés en forme de U et peuvent être emboîtés sur un côté (21, 22) frontal, tourné vers le côté (20) avant du châssis équipé, d'un rail (1, 31) transversal.

5. Châssis équipé suivant la revendication 4, dans lequel
a) un rail (1, 31) transversal comporte au moins une rainure (3) réceptrice s'étendant transversalement, notamment pour l'engagement d'éléments (36) de maintien pour les éléments (29) avant de modules plats, et
b) les moyens (11) de maintien en forme de U peuvent être emboîtés sur la bordure (5 ; 39) de délimitation, d'une rainure (3 ; 37) réceptrice s'étendant transversalement, qui est tournée vers le côté intérieur du châssis équipé.

6. Châssis équipé suivant la revendication 4 ou 5, dans lequel la baguette (11) de maintien en forme de U comporte une barrette (25) d'appui possédant un bord (28) longitudinal à partir duquel sont écartées les branches (15) des ressorts (14) de contact.

7. Châssis équipé suivant la revendication 6, dans lequel
a) des branches (13, 18) de liaison sont coudées approximativement à angle droit à partir de la barrette (25) d'appui, branches qui s'appliquent sur un côté (21, 22) frontal, tourné vers le côté (20) avant du châssis équipé, d'un rail (1, 31) transversal, et
b) des lames (12, 42) de serrage sont à nouveau coudées approximativement à angle droit à partir des branches (13, 18) de liaison, lames qui entourent le rail (1) transversal, notamment la bordure (5 ; 39) de délimitation supérieure de la rainure (3 ; 37) réceptrice s'étendant transversalement.

8. Châssis équipé suivant la revendication 7, dans lequel les ressorts (14) de contact sont écartés en direction du côté (20) avant ou arrière du châssis équipé à partir du bord (28) longitudinal entre la barrette (25) d'appui et les branches (13, 18) de liaison.

9. Châssis équipé suivant l'une des revendications 4 à 8, dans lequel deux moyens (11) de maintien en forme de U de la baguette (10 ; 38) élastique de contact sont respectivement reliés entre eux au moyen d'une branche (26) transversale, et un ressort (14) de contact est disposé entre eux.

10. Châssis équipé suivant la revendication 7 ou 8, dans lequel deux branches (13, 18) de liaison sont respectivement reliées entre elles au moyen d'une branche (26) transversale, et un ressort (14) de contact est disposé entre elles.

11. Châssis équipé suivant l'une des revendications 6 à 10, dans lequel les barrettes (25) d'appui associées à des branches (15) de ressort écartées forment une barrette ininterrompue, d'un seul tenant (figure 7).

12. Châssis équipé suivant l'une des revendications précédentes, dans lequel
a) des poignées (43, 55) à levier sont installées aux extrémités de l'élément (29) avant d'un module (32) plat, leur actionnement permettant au moins de soulever le module (32) plat hors du châssis équipé, et
b) les poignées (43, 55) à levier comportent au moins une face (47) de repoussement cintrée qui, lorsque la poignée (43, 55) à levier est actionnée pour soulever le module (32) plat hors du châssis équipé, s'appuie et roule sur la baguette (10 ; 38) élastique de contact.
